(19) Europäisches Patentamt
European Patent Office
Office européen des brevets

(11) **EP 2 642 662 B1**

(12) **FASCICULE DE BREVET EUROPEEN**

(45) Date de publication et mention
de la délivrance du brevet:
**07.10.2020 Bulletin 2020/41**

(51) Int Cl.:
***H03H 9/17*** *(2006.01)*      ***H03H 9/02*** *(2006.01)*

(21) Numéro de dépôt: **13159872.4**

(22) Date de dépôt: **19.03.2013**

(54) **Résonateur HBAR comportant une structure d'amplification de l'amplitude d'au moins une résonance dudit résonateur et procédés de réalisation de ce résonateur**

HBAR-Resonator, der eine Amplitudenverstärkungsstruktur von mindestens einer Resonanz des entsprechenden Resonators umfasst, und Verfahren zur Herstellung dieses Resonators

HBAR resonator comprising a structure for amplifying the amplitude of at least one resonance of said resonator and methods for producing said resonator

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.03.2012 FR 1252462**

(43) Date de publication de la demande:
**25.09.2013 Bulletin 2013/39**

(73) Titulaires:
- **COMMISSARIAT À L'ÉNERGIE ATOMIQUE ET AUX ÉNERGIES ALTERNATIVES**
**75015 Paris (FR)**
- **Centre National de la Recherche Scientifique**
**75016 Paris (FR)**

(72) Inventeurs:
- **Reinhardt, Alexandre**
**38400 Saint Martin d'Heres (FR)**
- **Ballandras, Sylvain**
**25000 Besancon (FR)**
- **Perruchot, François**
**38000 Grenoble (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
DE-A1-102009 047 807    US-A- 5 864 261
US-A1- 2006 119 453    US-A1- 2006 170 519

- **PIJOLAT M ET AL: "LiNbO3 Film Bulk Acoustic Resonator", FREQUENCY CONTROL SYMPOSIUM (FCS), 2010 IEEE INTERNATIONAL, IEEE, PISCATAWAY, NJ, USA, 1 juin 2010 (2010-06-01), pages 661-664, XP031738433, ISBN: 978-1-4244-6399-2**
- **PIJOLAT M ET AL: "High quality factor lithium niobate electrostrictive HBAR resonators", FREQUENCY CONTROL AND THE EUROPEAN FREQUENCY AND TIME FORUM (FCS), 2011 JOINT CONFERENCE OF THE IEEE INTERNATIONAL, IEEE, 2 mai 2011 (2011-05-02), pages 1-3, XP032009268, DOI: 10.1109/FCS.2011.5977743 ISBN: 978-1-61284-111-3**
- **ALIEV G ET AL: "Hypersonic acoustic mirrors and microcavities in porous silicon", APPLIED PHYSICS LETTERS, A I P PUBLISHING LLC, US, vol. 96, no. 12, 22 March 2010 (2010-03-22), pages 124101-124101, XP012130564, ISSN: 0003-6951, DOI: 10.1063/1.3367747**

EP 2 642 662 B1

## Description

Le domaine de l'invention est celui des résonateurs à ondes de volume opérant à modes harmoniques élevés (HBAR, pour *High-overtone Bulk Acoustic Resonator*). De tels résonateurs présentent des coefficients de qualité très élevés à des fréquences de l'ordre de quelques GHz. Leur utilisation est envisagée dans des boucles d'oscillations destinées à la synthèse de fréquences ou de références de temps ultra-stables.

Actuellement, les résonateurs de type HBAR dérivent des utilisations d'harmoniques d'ordres élevés, pouvant aller de 10 à 100 fois la fréquence fondamentale dudit résonateur, dans des résonateurs à ondes de volume tels que les résonateurs à quartz par exemple. Leur application initiale était de permettre de limiter la décroissance du coefficient de couplage électromécanique d'un résonateur composite composé d'une couche piézoélectrique, de ses électrodes, et d'une couche additionnelle permettant un support mécanique, une compensation en température, ou bien même simplement la fabrication du résonateur.

Lorsque le substrat devient très épais par rapport à la couche piézoélectrique, on ne parle alors plus de résonateur composite, mais de résonateur HBAR ou d'OMR (pour *Overmoded Resonator*). Ces résonateurs possèdent des applications dans les domaines où de forts coefficients de qualité sont nécessaires. En effet, des résonateurs composés d'un film mince sur un substrat massif d'un matériau possédant de faibles pertes de propagation, tels que le quartz comme décrit dans l'article de H. Zhang, W. Pang, H. Yu et E.S. Kim, High-tone bulk acoustic resonators on sapphire, crystal quartz, fused silica and silicon substrates, J. Appl. Phys. vol 99, 124911 (2006), le YIG (*Ytrium Ion Garnet*), le tantalate de lithium comme décrit dans l'article de H.L. Salvo, M. Gottlieb et B.R. McAvoy, Shear mode transducers for high-Q bulk microwave resonators, in Proceedings of the 41st Annual Frequency Control Symposium, p. 388-390 (1982), le niobate de lithium comme décrit dans l'article de D. Gachon, E. Courjon, J. Masson, V. Petrini, J.Y. Rauch, S. Ballandras, LiNbO3-LiNbO3 high overtone bulk acoustic resonator exhibiting high Q.f product, in Proceedings of the 2007 IEEE Ultrasonics Symposium, p. 1417-1420, le corindon comme décrit dans l'article de K.M. Lakin, G.R. Kline et K.T. McCarron, High-Q microwave acoustic resonators and filters, IEEE Transactions on Microwave Theory and Techniques, vol 41 n°2, p. 2139-2146 (1993) ou le saphir comme décrit dans l'article de G.R. Kline, K.M. Lakin et K.T. McCarron, Overmoded high-Q resonators for microwave oscillators, in Proceedings of the 1993 IEEE International Frequency Control Symposium, p. 718, permettent d'obtenir des coefficients de qualité très grands à des fréquences relativement élevées (jusqu'à plus de 30 000 à 2 GHz).

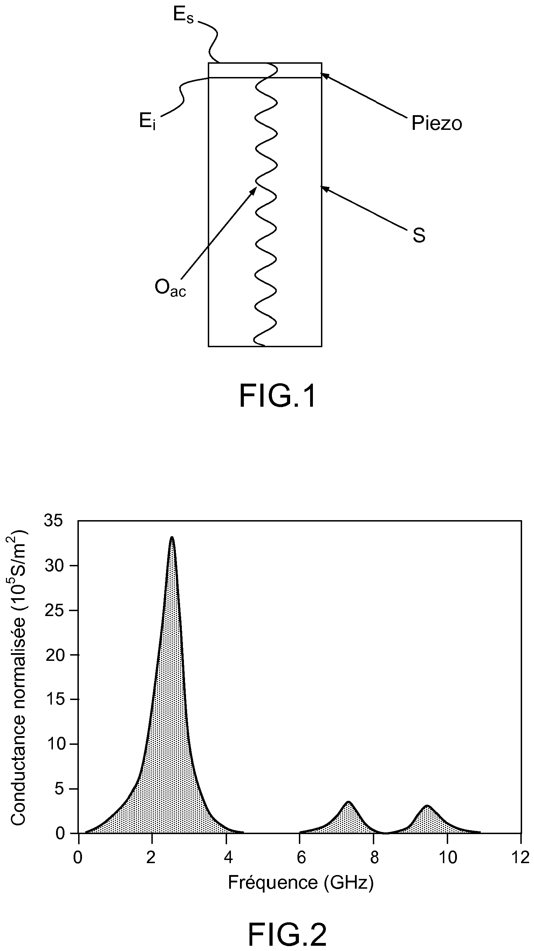

Dans cette configuration, illustrée sur la figure 1, le film mince piézoélectrique $P_{iézo}$ inséré entre une électrode supérieure Es et une électrode inférieure Ei, agit comme un transducteur d'excitation et de réception à la fois, tandis que l'on exploite les propriétés de propagation de l'onde acoustique $O_{ac}$ dans le substrat S. Pour obtenir des coefficients de qualité élevés, il est donc nécessaire d'employer des harmoniques d'ordre élevé afin que le transducteur n'occupe qu'une petite portion du résonateur complet et de ce fait qu'il n'intervienne que peu dans la longueur de propagation de l'onde.

Ce type de résonateurs présente l'avantage d'utiliser des substrats en matériau à faibles pertes et donc à fort coefficient de qualité.

L'inconvénient toutefois est que le spectre en fréquence d'un tel résonateur est constitué d'une série de résonances régulièrement espacées, l'écart en fréquence entre ces résonances correspondant à la fréquence de la résonance fondamentale du composant, en première approximation principalement définie par l'épaisseur du substrat et la vitesse de propagation des ondes dans celui-ci. Un tel spectre est représenté sur la figure 2 pour le cas d'un résonateur AIN / Silicium qui fournit la réponse électrique d'un résonateur HBAR, en terme de conductance normalisée en fonction de la fréquence.

La multitude de résonances, espacées de quelques MHz seulement pour des substrats de l'ordre de 500 $\mu$m à 1 mm d'épaisseurs, est problématique pour des applications de références de temps, car les circuits d'oscillateurs peuvent indifféremment se mettre en oscillation sur l'une ou l'autre des résonances et ainsi produire une fréquence a priori aléatoire. Des sauts d'une fréquence à l'autre peuvent même survenir en cas d'instabilités très importantes.

Pour pallier ces problèmes, plusieurs solutions ont été proposées dans la littérature.

Une première méthode consiste à augmenter l'espacement entre les résonances du HBAR. Cet écart est défini en première approximation par la relation :

$$\Delta f \approx \frac{V}{2e}$$

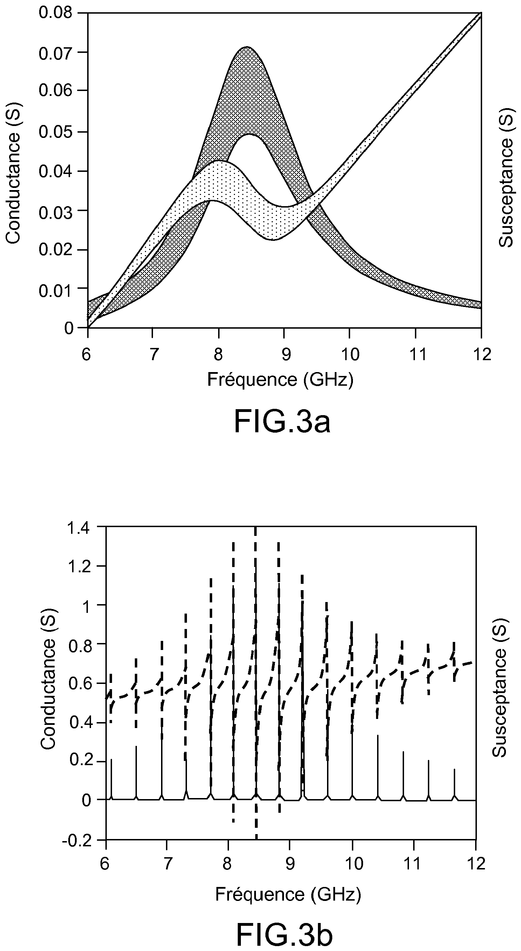

où *V* est la vitesse de l'onde acoustique exploitée dans le substrat et e est l'épaisseur de ce dernier. La vitesse de propagation étant une caractéristique intrinsèque du matériau, le seul moyen d'augmenter l'écart en fréquence $\Delta f$ est de diminuer l'épaisseur du substrat. A titre d'exemple, la figure 3 présente l'effet théorique de l'amincissement du substrat d'un résonateur AIN/Saphir de 400 à 25 $\mu$m.

Dans ce cas, la périodicité des résonances passe de 14 à 224 MHz. Avec un tel écart en fréquence, les risques de saut de fréquence d'une résonance à l'autre sont fortement limités, d'autant plus que les éléments du circuit d'oscillation présentent généralement une bande passante limitée et donc une tendance à atténuer les résonances non exploitées. Un autre avantage de cette méthode est qu'elle permet, comme le montrent les courbes des figures 3a et 3b qui illustrent l'évolution de la conductance et de la susceptance, en fonction de la fréquence respectivement dans les cas de résonateurs HBAR en AlN avec un substrat épais (400 $\mu$m) et un substrat mince (25 $\mu$m) de saphir, d'augmenter l'amplitude des pics de résonance, et donc de mieux les définir, en raison d'une augmentation du coefficient de couplage électromécanique des différentes résonances. Ce coefficient, qui représente la capacité du composant à convertir de l'énergie électrique en énergie mécanique, et vice-versa, est en effet fortement limité par la présence d'un substrat épais, qui ne contribue qu'au stockage d'énergie mécanique, mais pas à sa restitution sous forme électrique.

Malgré ces avantages, cette solution souffre toutefois de deux inconvénients majeurs :

- en diminuant l'épaisseur du substrat, on augmente la proportion prise par le volume du transducteur et des électrodes, et donc la contribution des couches possédant de relativement faibles coefficients de qualité mécaniques : pour de fortes réductions d'épaisseur, on note une dégradation notable du coefficient de qualité des résonances ;
- par ailleurs, si des solutions d'amincissement existent pour des matériaux comme le silicium ou le quartz, elles sont délicates à mettre en œuvre pour des matériaux comme le niobate de lithium où des problèmes de parallélisme entre la face érodée et la face native se posent (comme décrit dans l'article de M. Pijolat, S. Loubriat, S. Queste, D. Mercier, A. Reinhardt, E. Defaÿ, C. Deguet, L. Clavelier, H. Moriceau, M. Aïd et S. Ballandras, Large electromechanical coupling factor film bulk acoustic resonator with X-cut LiNbO3 layer transfer, Appl. Phys. Lett. 95, 182106 (2009)), mais aussi des problèmes de génération de défauts cristallins dans les matériaux amincis. Ces deux effets contribuent tous deux à une dégradation encore supérieure du coefficient de qualité du composant. Par ailleurs, pour certains matériaux tels que le saphir ou le diamant, les procédés d'amincissement sont quasiment inexistants.

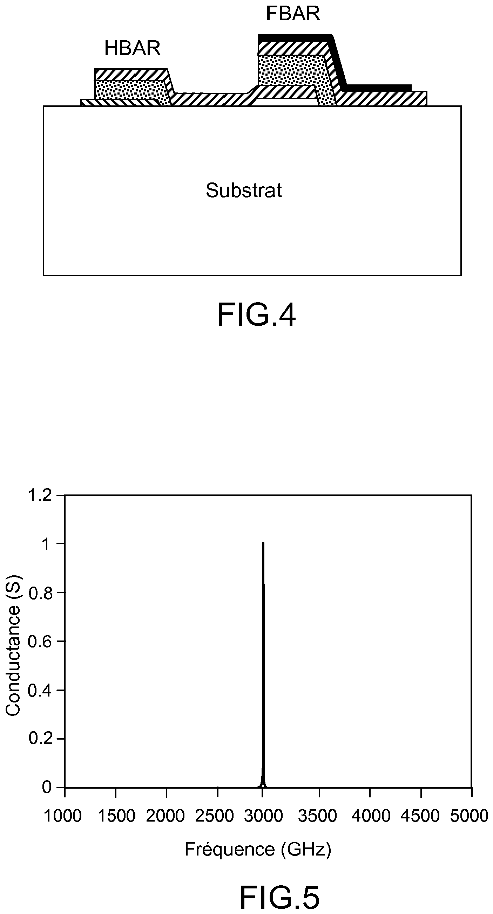

Les autres approches décrites dans la littérature proposent de contourner ces problèmes en ajoutant une structure filtrante aux résonateurs. Par exemple, des auteurs ont proposé de réaliser des filtres passe-bande à ondes de volume cointégrés avec des résonateurs HBAR comme décrit dans l'article de W. Pang, H. Zhang, J.J. Kim, H. Yu et E.S. Kim, High-Q single mode hightone bulk acoustic resonator integrated with surface-micromachined FBAR filter, Proceedings of the 2005 MTT-S International Microwave Symposium, p. 413. Ces filtres sont réalisés à partir de résonateurs obtenus par les mêmes étapes technologiques de dépôt d'électrodes et de la couche piézoélectrique, mais par-dessus une couche sacrifiée positionnée localement, et retirée en fin de fabrication pour laisser les résonateurs composant le filtre isolés acoustiquement du substrat par une lame d'air, comme le montre la figure 4. Le filtre passe-bande vient sélectionner uniquement une ou plusieurs résonances et atténue fortement les autres. Néanmoins, en pratique, les coefficients de qualité obtenus se sont avérés être relativement faibles (3600 à 2.5 GHz), en raison des pertes électriques supplémentaires apportées par la présence du filtre comme décrit dans l'article de W. Pang, H. Zhang, J.J. Kim, H. Yu et E.S. Kim, High-Q single mode high-tone bulk acoustic resonator integrated with surface-micromachined FBAR filter, Proceedings of the 2005 MTT-S International Microwave Symposium, p. 413.

Dans ce contexte, le Demandeur propose une nouvelle conception de résonateur HBAR, permettant la sélection d'une résonance particulière d'un résonateur HBAR en vue de favoriser son insertion dans un circuit d'oscillation. Pour ce faire, le Demandeur est parti du constat que l'enveloppe de la réponse d'un résonateur HBAR est à l'image de la distribution des champs acoustiques dans la couche piézoélectrique comme décrit dans la publication de A. Reinhardt, Simulation, conception et réalisation de filtres à ondes de volume dans des couches minces piézoélectriques, Thèse de l'Université de Franche-Comté (2005). Ceci inclut deux contributions majeures qui sont :

- la distribution des champs : le coefficient de couplage électromécanique du composant est maximum lorsque l'épaisseur de la couche piézoélectrique correspond à une demi-longueur d'onde de l'onde de volume exploitée, ou à défaut correspond à un multiple impair de cette demi-longueur d'onde. Or l'amplitude des pics de résonance est directement proportionnelle, entre autres, au coefficient de couplage électromécanique du résonateur. Ce phénomène est par exemple responsable de l'enveloppe des pics de résonance visible sur la figure 2 et qui présente un maximum aux alentours de 2.5 GHz ;
- la quantité de charges générées par le matériau piézoélectrique est directement proportionnelle, à structure égale, à l'amplitude des champs mécaniques dans la couche piézoélectrique. Par conséquent, la valeur de l'admittance ou de l'impédance qu'obtient le résonateur est directement liée à l'amplitude des champs générés dans la couche piézoélectrique.

Ainsi et plus précisément, la présente invention a pour objet un résonateur HBAR comportant un substrat, un transducteur piézoélectrique, ledit transducteur comprenant au moins une couche piézoélectrique, au moins deux électrodes et présentant des fréquences de résonance Fi correspondant à des longueurs d'onde $\lambda$i, le résonateur comprenant en outre une structure d'amplification comportant au moins une cavité résonante disposée sur le substrat entre ledit transducteur et ledit substrat ou dans ledit substrat, cette structure d'amplification étant apte à résonner mécaniquement à au moins une des fréquences de résonance Fi dudit transducteur correspondant à ladite longueur d'onde λi, de façon à amplifier l'amplitude de la résonance mécanique générée à ladite fréquence ; la cavité résonante présentant un spectre de transmission acoustique caractérisé par des niveaux relativement bas, typiquement pouvant être inférieur à environ 0,5 et ce sur une gamme de fréquence encadrant la au moins fréquence =i de travail, mais avec des pics de transmission localisés à la fréquence Fi d'intérêt; ladite cavité présentant une épaisseur sensiblement égale à nλi/2 avec n entier non nul ; caractérisé en ce que :

la cavité résonante est composée d'une couche demi-onde d'AIN encadrée par deux miroirs de Bragg partiels composés de couches quart d'onde de $SiO_2$ et d'AIN ou la cavité résonante est définie dans ledit substrat, et délimitée par des structures élémentaires de miroirs réfléchissants à ladite fréquence Fi enterrées dans ledit substrat, ces structures faisant partie de ladite cavité résonante.

Le Document D1 PIJOLAT M ET AL : « LiNbO3 Film Bulk Acoustic Resonator » IEEE, 1 juin 2010, pages 661-664 décrit un résonateur HBAR. Néanmoins, Il n'est pas enseigné la présence d'une structure d'amplification comportant au moins une cavité résonante telle que définie dans la présente demande.

La demande de brevet US 2006/119453 décrit également un résonateur HBAR dans lequel il n'est pas enseigné d'utiliser la cavité résonante telle que définie dans la présente invention.

La demande de brevet US 5864261 décrit également un résonateur HBAR comprenant une cavité résonante constituée d'un miroir réfléchissant.

Selon une variante de l'invention, le transducteur comporte une électrode inférieure et une électrode supérieure.

Selon une variante de l'invention, le transducteur comporte deux électrodes supérieures.

Selon une variante de l'invention, le substrat est en saphir, ou en quartz, ou en niobate de lithium, ou en tantalate de lithium, ou en corindon ou en silicium, ou en germanium ou en arséniure de gallium.

Le substrat de l'invention est avantageusement massif (bulk) mais il peut également être multicouches par exemple comprenant du silicium avec une couche d'oxyde. Par ailleurs, il est choisi de préférence à faibles pertes acoustiques auxdites fréquences de résonance Fi.

Selon une variante de l'invention, la couche piézoélectrique est en AIN, ou en $LiNbO_3$.

La présente invention a aussi pour objet deux procédés de réalisation d'un résonateur HBAR tels que définis par les revendications indépendantes 6 et 7.

Selon une variante de l'invention, le procédé comporte la réalisation dudit transducteur piézoélectrique sur un substrat hôte et est caractérisé en ce qu'il comprend les étapes suivantes :

- la réalisation d'une première partie d'une cavité résonante à la surface d'un substrat donneur en matériau piézoélectrique ;
- la réalisation d'une seconde partie de ladite cavité résonante à la surface d'un substrat hôte ;
- le collage de la première et de la seconde parties de la cavité résonante de manière à définir une cavité résonante unique à la fréquence Fi ;
- une opération de délimitation d'une couche de matériau dans ledit substrat donneur de manière à obtenir ladite couche de matériau piézoélectrique ;
- la réalisation d'au moins une série d'électrodes à la surface de ladite couche piézoélectrique séparée.

Selon une variante de l'invention, la première et la deuxième parties étant des demi cavités, chacune de ces demi cavités comprend le dépôt d'une couche d'épaisseur égale à nλi/4 avec n entier non nul.

Selon une variante de l'invention, l'opération de délimitation d'une couche de matériau dans ledit substrat donneur comprend :

- la réalisation d'une zone fragilisée dans ledit substrat de manière à délimiter dans ledit substrat, ladite couche piézoélectrique ;
- la séparation de ladite couche piézoélectrique dudit substrat donneur.

Selon une variante de l'invention, la réalisation d'une zone fragilisée dans ledit substrat est effectuée par implantation.

Selon une variante de l'invention, l'opération de délimitation d'une couche de matériau dans ledit substrat donneur comprend une opération d'amincissement dudit substrat donneur.

Selon une variante de l'invention, les substrats donneur et hôte sont en $LiNbO_3$.

Selon une variante de l'invention, le collage des deux demi-cavités est un collage moléculaire.

Selon une variante de l'invention, le procédé comporte en outre une opération préalable de réalisation d'une couche de contact métallique à la surface dudit substrat hôte.

Selon une variante de l'invention, le matériau piézoélectrique de la plaque est en niobate de lithium.

Selon une variante de l'invention, les miroirs sont réalisés par implantation d'atomes ou d'ions à des énergies différentes de manière à régler la profondeur d'implantation.

L'invention sera mieux comprise et d'autres avantages apparaîtront à la lecture de la description qui va suivre donnée à titre non limitatif et grâce aux figures annexées parmi lesquelles :

- la figure 1 illustre le schéma d'un résonateur HBAR de type $LiNbO_3$ / $LiNbO_3$ ;
- la figure 2 illustre la réponse électrique d'un résonateur HBAR AIN/Silicium ;

- les figures 3a et 3b illustrent l'effet de l'amincissement du substrat sur un résonateur HBAR AlN/Saphir en montrant les réponses électriques pour un substrat de 400 $\mu$m et de 25 $\mu$m ;
- la figure 4 illustre un schéma de coupe d'intégration de résonateur HBAR et de résonateur FBAR compris dans le filtre passe-bande ;
- la figure 5 illustre la réponse électrique du transducteur Mo/AlN/Al considéré seul ;
- la figure 6 illustre la réponse électrique d'un HBAR Saphir / Mo / AlN / Al et celle du transducteur seul indiqué en référence ;
- la figure 7 illustre le spectre de transmission de microcavités acoustiques composées d'alternances de couches de $SiO_2$ et d'AlN : microcavité d'AlN entourée de miroirs de Bragg partiels composés de 3 ou de 5 couches quart d'onde.
- les figures 8a à 8d illustrent les spectres de conductance obtenus dans le cas d'une cavité délimitée par des miroirs à 3 et à 5 couches et des agrandissements ;
- la figure 9 illustre le spectre de conductance pour une structure à microcavité possédant des miroirs de Bragg partiels à une seule couche quart d'onde de $SiO_2$ ;
- la figure 10 illustre le spectre de conductance pour une structure à microcavité possédant des miroirs de Bragg partiels à une seule couche quart d'onde de $SiO_2$ et un substrat de 500 $\mu$m d'épaisseur ;
- les figures 11a à 11h illustrent un exemple illustratif de procédé de réalisation d'un résonateur HBAR : ne faisant pas partie de l'invention ;
- les figures 12a à 12f illustrent un exemple de procédé de réalisation d'un résonateur HBAR selon l'invention;
- les figures 13a à 13d illustrent un exemple de procédé de réalisation d'un résonateur HBAR selon l'invention;
- les figures 14a à 14k illustrent un exemple illustratif de procédé de réalisation d'un résonateur HBAR ne faisant pas partie de l'invention.

La présente invention présente l'avantage de permettre l'augmentation de l'amplitude d'un ou plusieurs pics de résonance, par rapport à celle d'un résonateur HBAR classique composé uniquement d'un transducteur et d'un substrat. Par ailleurs, elle permet également une sélection modale, en manipulant l'enveloppe des pics de résonance de manière à la rendre la plus étroite possible et par conséquent à atténuer les pics de résonance adjacents. Ces effets étant obtenus uniquement par une modification de la structure de résonateurs, cette dernière n'entraine pas une dégradation des coefficients de qualité aussi forte que celle obtenue par ajout de filtres extérieurs. Par ailleurs, elle est compatible avec une partie des améliorations de résonateurs HBARs connues par l'homme du métier qui peuvent avantageusement la compléter : compensation en température, composants quadripôles pour réaliser un composant possédant une architecture différentielle comme décrit dans la demande de brevet FR 2 938 136 de D. Gachon et S. Ballandras, *Eléments de filtres par couplage transverse sur structures résonantes à ondes de volume à résonances harmoniques multiple,* amincissement du substrat, ... Enfin, elle est applicable virtuellement à tout type de combinaison de substrat et de matériau piézoélectrique.

Exemple de réalisation :

Un exemple de résonateur selon la présente invention comporte un film mince de 1 $\mu$m de Nitrure d'Aluminium (AlN) comme couche piézoélectrique, disposé entre une électrode inférieure de 250 nm de Molybdène et une électrode supérieure de 250 nm d'Aluminium. Une telle structure présente une réponse électrique en impédance telle que celle représentée sur la figure 5 : une résonance nettement définie à 2950 MHz. Cette réponse électrique peut être aussi bien obtenue par un modèle de Mason (J.F. Rosenbaum, Bulk Acoustic Wave Theory and Devices, Artech House, Boston, 1945), que par d'autres modèles numériques tels que la méthode de la matrice de réflexion (A. Reinhardt, T. Pastureaud, S. Ballandras et V. Laude, Scattering matrix method for modeling acoustic waves in piezoelectric, fluid and metallic multilayers, Journ. Appl. Phys. vol 94, n°10, p. 6923-6931 (2003)).

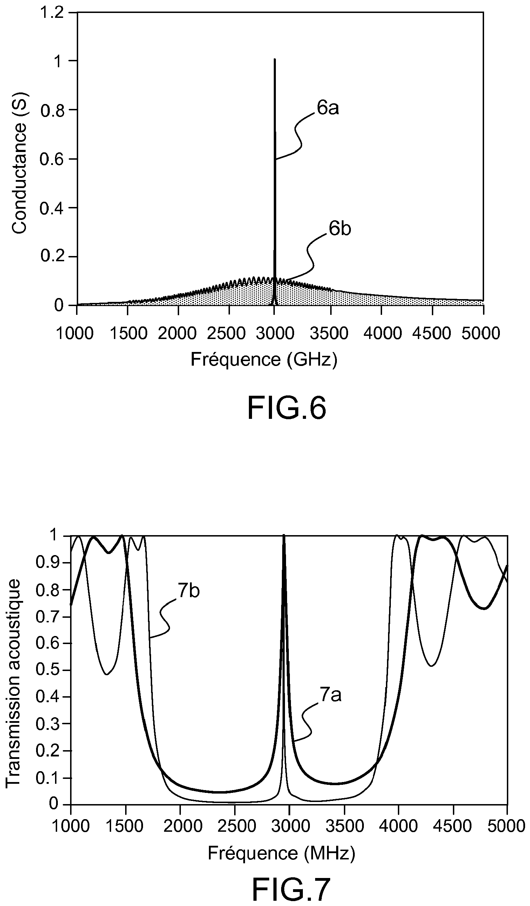

Si l'on considère maintenant la réponse d'un résonateur HBAR formé de l'empilement précédent réalisé sur un substrat de saphir (de coupe dite C, par exemple) de 1 mm d'épaisseur, on obtient la réponse électrique représentée sur la figure 6.

La courbe 6a est relative à la réponse électrique d'un transducteur seul.

La courbe 6b est relative à la réponse électrique d'un HBAR Saphir / Mo / AlN / Al.

Celle-ci est constituée d'un grand nombre de résonances régulièrement espacées d'approximativement 5.5 MHz. Chacun de ces pics présente une largeur a mi-hauteur de l'ordre de 100 kHz, ce qui est représentatif de coefficients de qualité de l'ordre de 37 000. L'amplitude de ces résonances présente une enveloppe qui est maximale aux alentours de 2.7 GHz, relativement près de la fréquence de résonance du transducteur seul (le décalage entre ces deux fréquences étant dû à un décalage du plan de réflexion théorique par rapport à l'interface électrode inférieure / substrat en présence d'un substrat).

En considérant à présent une structure de microcavité résonante composée d'une couche demi-onde d'AlN encadrée par deux miroirs de Bragg partiels composés de couches quart d'onde de $SiO_2$ et d'AlN. Pour une fréquence de 2950 MHz, les épaisseurs des couches quart d'onde de $SiO_2$ et d'AlN sont respectivement de 560 nm et 940 nm, et la couche demi-onde d'AlN est de 1.8 $\mu$m d'épaisseur. La figure 7 montre le spectre de la transmission acoustique à travers des empilements de ce type pour des miroirs de Bragg partiels composés de 3 couches (courbe 7a) et 5 couches (courbe 7b) quart d'onde. Ces spectres, pouvant toujours être calculés en utilisant un modèle de Mason ou un modèle de matrice de réflexion, présentent tous un fort pic centré sur 2.7 GHz, correspondant à la fréquence de résonance de cette cavité. A cette fréquence, la transmission proche de 1 indique que la structure est quasiment acoustiquement « invisible » : les ondes acoustiques peuvent donc librement se propager du transducteur vers le substrat : ce dernier est donc exploité pour la résonance acoustique. Autour de cette fréquence, la cavité présente un coefficient de transmission très faible, et agit donc comme un isolant, venant limiter la transmission des ondes du transducteur vers le substrat. En pratique, ce dernier sera « caché », et n'intervient donc pas, ou très peu, dans la réponse électrique. On peut également remarquer que plus les miroirs de Bragg partiels comprennent de couches, plus la finesse de la résonance de la cavité est prononcée : la gamme en fréquence où celle-ci est passante est donc grandement réduite.

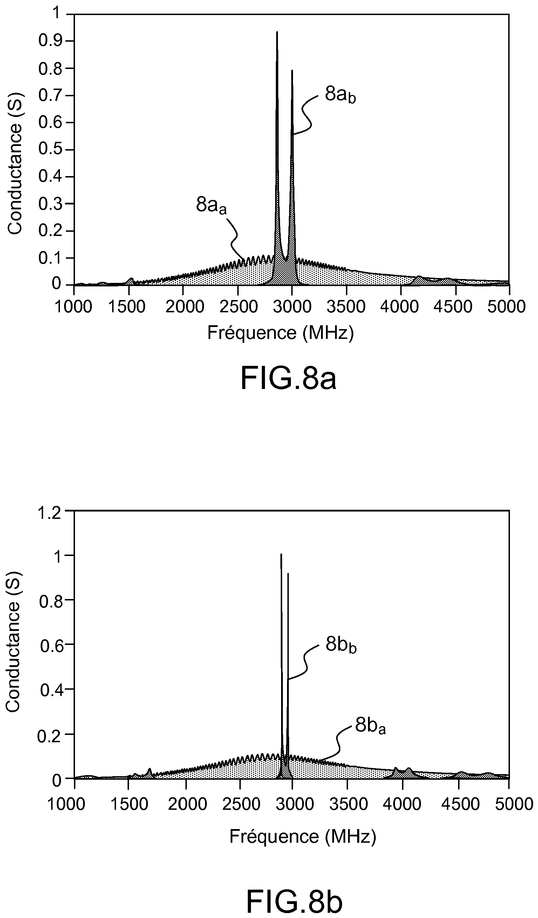

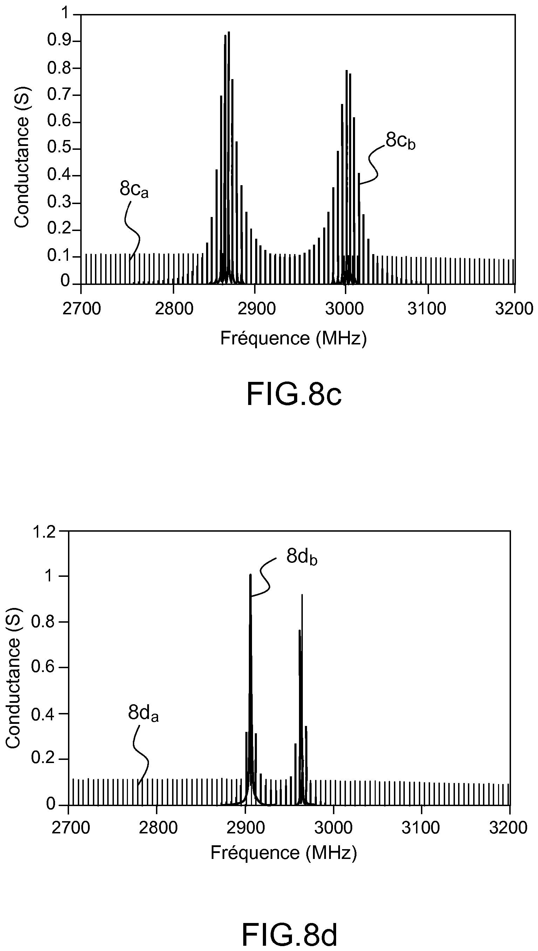

Selon la présente invention, on vient intercaler ces structures de microcavités entre le transducteur d'une part et le substrat d'autre part. Les figures 8a à 8d montrent les spectres de conductance obtenus dans le cas de résonateurs et d'une cavité délimitée par des miroirs à 3 et 5 couches.

Les courbes $8a_a$ et $8a_b$ sont relatives aux réponses de résonateurs HBAR seul et HBAR avec cavité délimitée par des miroirs de Bragg à 3 couches.

Les courbes $8b_a$ et $8b_b$ sont relatives aux réponses de résonateurs HBAR seul et HBAR avec cavité délimitée par des miroirs de Bragg à 5 couches avec détail des réponses autour de la fréquence d'intérêt.

Les courbes $8c_a$ et $8c_b$ sont relatives aux réponses agrandies de résonateurs HBAR seul et HBAR avec cavité délimitée par des miroirs de Bragg à 3 couches.

Les courbes $8d_a$ et $8d_b$ sont relatives aux réponses agrandies de résonateurs HBAR seul et HBAR avec cavité délimitée par des miroirs de Bragg à 5 couches avec détail des réponses autour de la fréquence d'intérêt.

Comme on pouvait s'y attendre, l'enveloppe de la réponse présente un maximum autour de la résonance de la couche piézoélectrique, où son amplitude est fortement augmentée par rapport à la réponse d'un HBAR classique. De plus, quelques résonances uniquement atteignent des niveaux fortement élevés. Par contre, une évaluation des coefficients de qualité montre que ceux-ci sont réduits à 5000 pour la structure avec des miroirs à trois couches et à 2000 pour la structure avec des miroirs à cinq couches. Cet effet est dû à une forte amplitude des champs acoustiques dans les couches de la microcavité et du résonateur, qui possèdent des pertes acoustiques beaucoup plus fortes que celles du substrat.

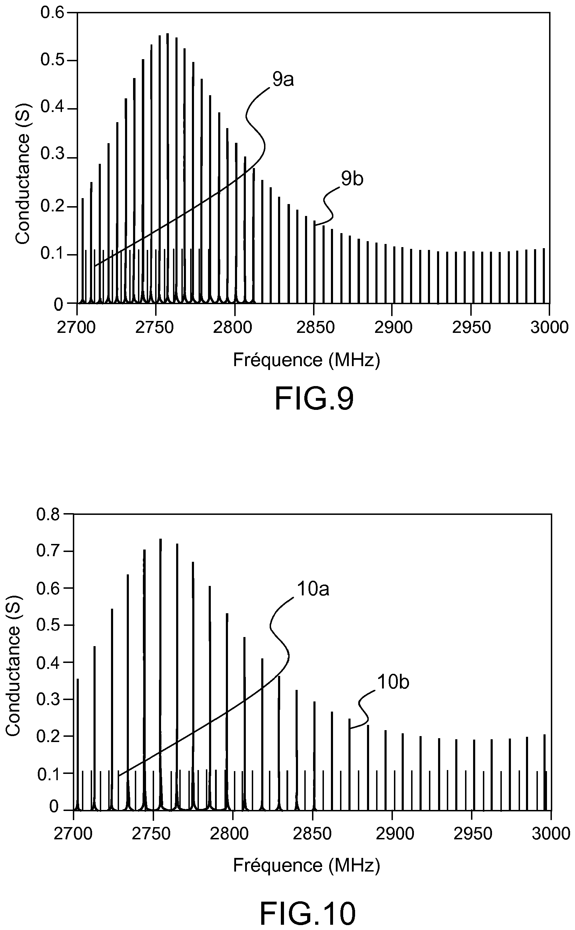

Le cas présenté ci-dessus est un cas extrême de séparation modale, mais qui en contrepartie présente une diminution forte du coefficient de qualité des résonances. En pratique, il peut être avantageux de diminuer le nombre de couches présentes dans l'empilement afin de trouver un meilleur compromis entre sélection modale et coefficient de qualité. Par exemple, si l'on n'utilise que de simples couches quart d'onde en guise de miroir de Bragg partiel entourant une couche demi-onde d'AlN, on obtient la réponse représentée en figure 9.

La courbe 9a est relative à la réponse d'un HBAR seul, la courbe 9b étant relative à la réponse d'un HBAR avec une structure à microcavité possédant des miroirs de Bragg partiel à une seule couche quart d'onde de $SiO_2$

L'amplitude des pics de conductance a baissé, de même que l'enveloppe présente un profil plus évasé. Par contre, la résonance la plus proche de 2750 MHz présente un coefficient de qualité de l'ordre de 18400, ce qui est considérablement plus que dans les deux configurations précédentes.

La présente invention a été exposée ci-dessus dans ses principes généraux reposant sur quelques exemples mais peut-être déclinée en faisant varier les épaisseurs des couches, leur nombre et leur nature afin de parvenir à des compromis sélection modale / coefficient de qualité satisfaisant les contraintes d'applications particulières.

Par ailleurs, ce dimensionnement n'exclut pas l'utilisation d'autres approches déjà connues. Par exemple, il est possible de reprendre le dernier exemple, mais en considérant un substrat de 500 $\mu$m d'épaisseur au lieu d'un substrat de 1 mm. Dans ce cas, l'espacement entre chaque pic est doublé, ce qui conduit à la réponse donnée sur la figure 10.

La courbe 10a est relative à la réponse avec un HBAR seul, la courbe 10b étant relative à un HBAR avec une structure à microcavité possédant des miroirs de Bragg partiels à une seule couche quart d'onde de $SiO_2$ et un substrat de 500 $\mu$m d'épaisseur

Ceci permet à ce pic de se détacher un peu mieux en amplitude même si son coefficient de qualité est diminué à 14000. Sur cette base, il serait également possible de remplacer des résonateurs par des structures quadripôles (comme décrit dans la demande de brevet FR 2 938 136), ainsi que d'utiliser les couches de $SiO_2$ de la microcavité à des fins de compensation en température.

Exemple illustratif de réalisation d'un résonateur HBAR ne faisant pas partie de l'invention comprenant un résonateur AlN sur un substrat en saphir :

Ce résonateur utilise un transducteur en AlN réalisé sur un substrat de saphir coupe C. Entre les deux, on vient intercaler une microcavité $SiO_2/AlN/SiO_2$.

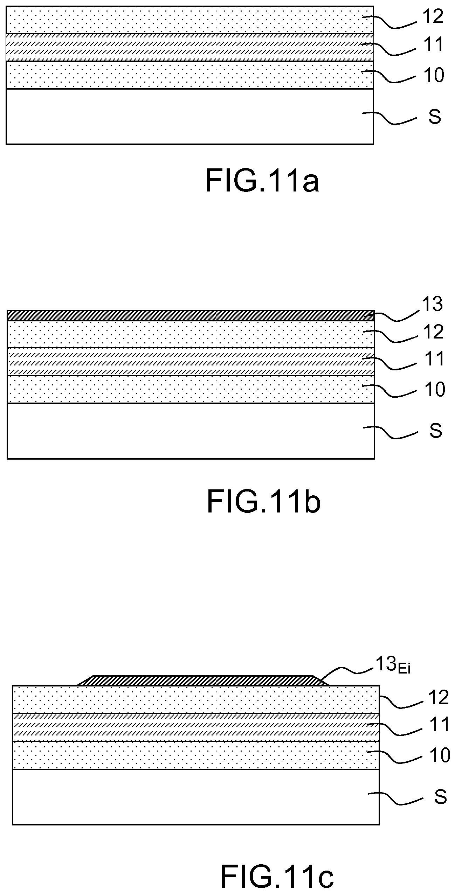

Selon une première série d'étapes illustrée en figure 11a, on procède au nettoyage d'un substrat S, puis au dépôt d'une couche 10 en $SiO_2$ (par exemple de 560 nm) par PECVD (Plasma Enhanced Chemical Vapo Déposition) à 400°C, suivi d'une opération de polissage mécano-chimique afin de lisser la surface. On procède alors au dépôt d'une couche 11, d'AlN par pulvérisation cathodique réactive d'une cible d'aluminium en présence d'azote (par exemple de 960 nm d'épaisseur). On réalise alors le dépôt d'une seconde couche 12, de $SiO_2$ par PECVD, présentant la même épaisseur que la première couche 10.

Selon une seconde étape, on procède au dépôt d'une couche d'accroche puis une couche 13 de molybdène d'épaisseur 200nm destinée à réaliser l'électrode inférieure du résonateur, par pulvérisation cathodique.

Lors d'une troisième étape illustrée en figure 11c, on procède à l'enduction de résine et par lithographie puis fluage à 200°C pendant 15 minutes. On procède alors par gravure sèche par RIE, fluorée du molybdène puis retrait de résine, permettant la définition de l'électrode $13_{Ei}$.

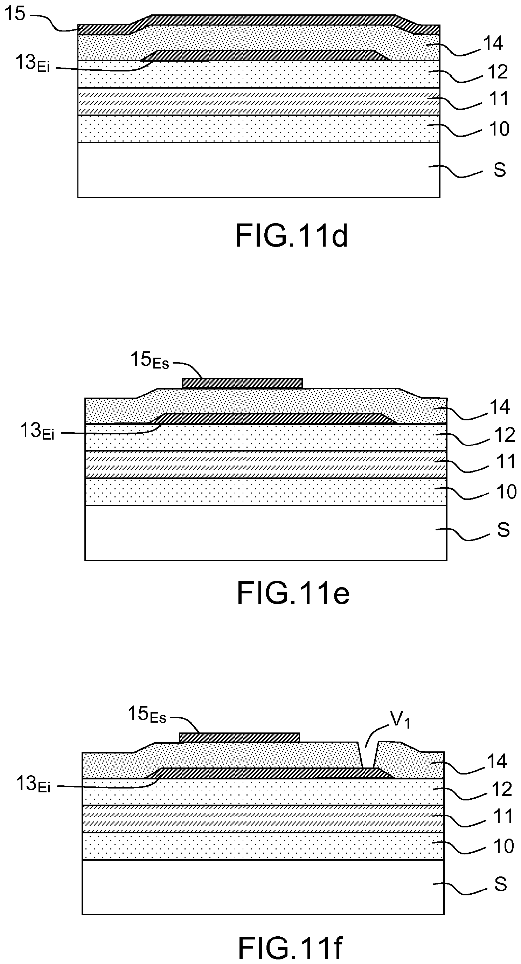

Lors d'une quatrième étape, illustrée en figure 11d, on procède au dépôt d'une couche 14 d'AlN d'épaisseur 1 $\mu$m, par pulvérisation cathodique réactive DC puisée, à une température de 300°C, puis au dépôt d'une couche 15 de molybdène, d'épaisseur 200 nm, par pulvérisation cathodique.

Lors d'une cinquième étape illustrée en figure 11e, on procède à l'enduction de résine et à une opération de lithographie, puis gravure sèche fluorée de molybdène et retrait de résine pour définir l'électrode supérieure $15_{Es}$.

Lors d'une sixième étape illustrée en figure 11f, on réalise un via $V_1$, par enduction de résine et lithographie, puis gravure humide de l'AlN dans un bain de $H_3PO_4$ à 130°C. On procède alors à des opérations de rinçage, et retrait de résine.

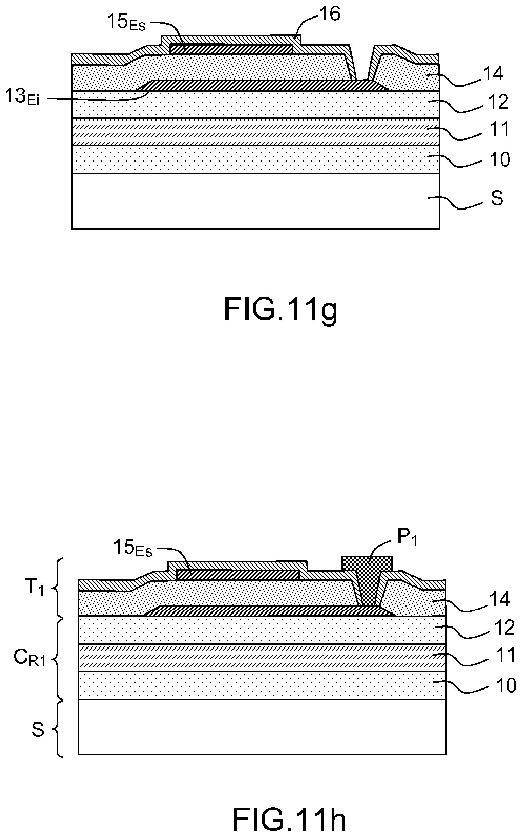

Lors d'une septième étape illustrée en figure 11g, on procède au dépôt d'une couche 16 de nitrure de silicium (SiN) par PECVD (200 nm), puis à des opérations d'enduction de résine et de lithographie. On réalise ensuite des opérations de gravure sèche et retrait de résine.

Lors d'une huitième étape illustrée en figure 11h, on réalise un dépôt d'Aluminium-cuivre d'épaisseur de 1 $\mu$m, par pulvérisation cathodique. On procède à l'enduction de résine et à de la lithographie puis à des opérations de gravure sèche chlorée, rinçage et retrait de résine. On définit ainsi un plot de contact $P_1$.

Il est à noter qu'il est possible d'utiliser la présence de couches de $SiO_2$ à des fins de compensation en température du composant. Sous sa forme la plus simple, la cavité résonante pourrait même se limiter à une unique couche de $SiO_2$ possédant une épaisseur égale à un multiple d'une demi-longueur d'onde. Dans ce cas précis, à ce critère s'ajoute également celui de parvenir à partiellement compenser le résonateur en température.

La figure 11h met en évidence la structure de résonateur HBAR selon l'invention comportant une zone de substrat S, une zone de cavité résonante $C_{R1}$ et une zone de transduction $T_1$.

Exemple de réalisation d'un résonateur HBAR de l'invention comprenant un résonateur $LiNbO_3$ / $LiNbO_3$ utilisant un report de couche mince piézoélectrique :

La présente invention peut également être utilisée pour la réalisation de résonateurs utilisant une couche piézoélectrique en niobate de lithium. Par rapport au mode de réalisation précédent utilisant une couche d'AlN, le niobate de lithium en coupe X permet l'utilisation d'ondes de volume de cisaillement, moins sujettes à des pertes par rayonnement dans l'air. Afin de simplifier le procédé de réalisation, ces couches monocristallines de $LiNbO_3$ sont généralement reportées sur des substrats du même matériau. L'inconvénient est que la coupe X du $LiNbO_3$ présente en pratique deux ondes de cisaillement couplées piézoélectriquement, ce qui peut conduire, si l'on ne prend pas de précaution, à des réponses spectrales présentant deux séries de périodicités, une pour chaque polarisation, ce qui multiplie par deux le nombre de résonances du composant. Il a néanmoins été montré que par une désorientation volontaire des axes cristallins de la couche reportée et du substrat, on peut exploiter des effets de conversion de mode entre les deux couches de manière à ce que seule une de ces deux ondes de cisaillement subsiste en pratique (comme décrit dans l'article de M. Pijolat, D. Mercier, A. Reinhardt, E. Defaÿ, C. Deguet, M. Aïd , J. S. Moulet, B. Ghyselen, S. Ballandras, Mode conversion in high overtone bulk acoustic wave resonators, Proceedings of the 2009 International Frequency Control Symposium, p. 290-294 (2009)).

Une des méthodes permettant d'obtenir de tels résonateurs consiste à employer le procédé Smart Cut. Ce procédé utilise une couche d'oxyde de silicium pour coller la couche reportée sur un substrat hôte. Normalement, cette couche d'oxyde est visée fine, afin qu'elle perturbe le moins possible la réponse électrique du résonateur. Dans le présent exemple, le Demandeur cherche au contraire à l'exploiter et à en faire une microcavité, dimensionnée pour que son épaisseur soit d'un quart de longueur d'onde de l'onde de cisaillement exploitée, à la fréquence désirée.

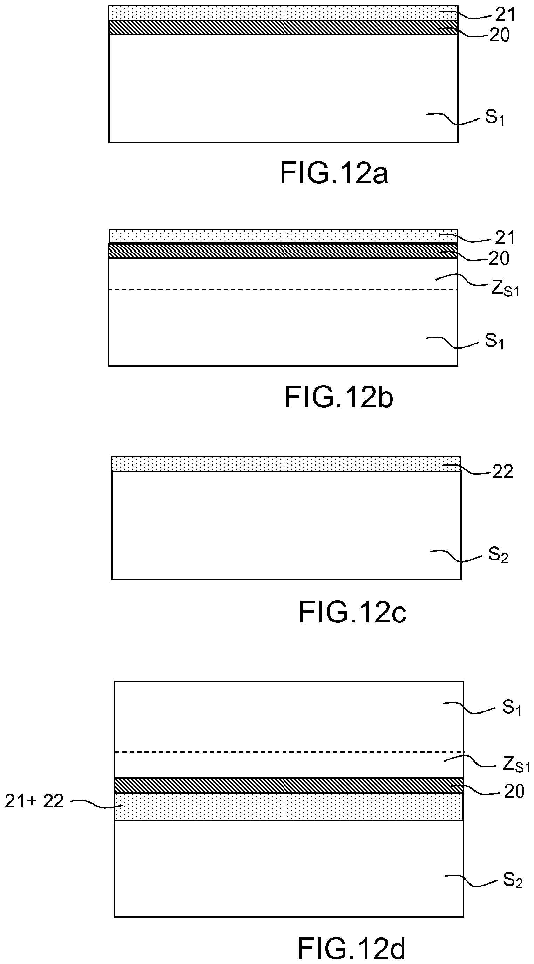

Un exemple d'un tel procédé est illustré en figures 12a à 12f.

Lors d'une première étape illustrée en figure 12a, on procède au nettoyage d'un substrat $S_1$ dit « donneur », puis au dépôt d'une couche 20 de molybdène d'épaisseur 200 nm par pulvérisation cathodique. On réalise alors le dépôt d'une couche d'oxyde de silicium 21 par PECVD à basse température (100 nm d'épaisseur).

Dans une seconde étape illustrée en figure 12b, on procède à l'implantation ionique d'atomes d'hélium afin de créer une zone de défauts à la profondeur désirée, de manière à définir une zone isolée $Z_{S1}$.

Dans une troisième étape, illustrée en figure 12c, on procède au dépôt d'une couche 22 d'oxyde de silicium sur un substrat S$_2$ dit « Hôte » (épaisseur : 3.9 µm, soit une demi-longueur d'onde) par PECVD à basse température.

Dans une quatrième étape illustrée en figure 12d, on procède à une opération de collage moléculaire des deux substrats au niveau des couches d'oxyde de silicium, de manière à former un angle de 20° entre les méplats des deux substrats.

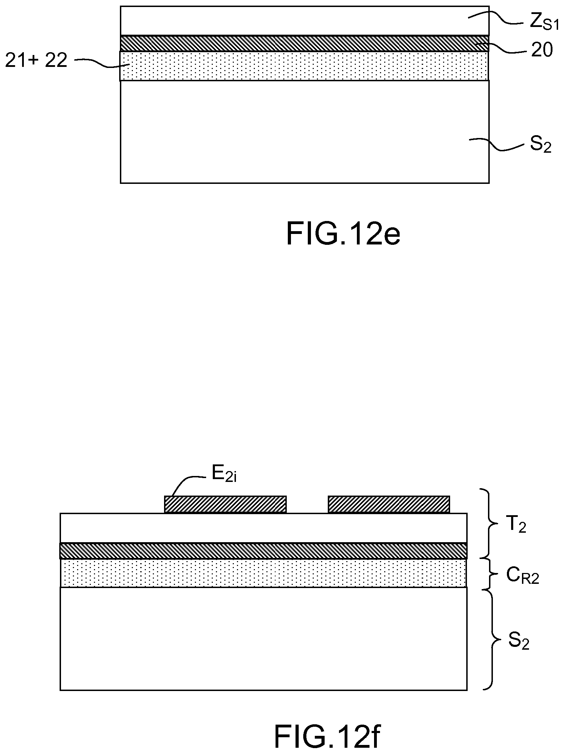

Dans une cinquième étape illustré en figure 12e, on réalise une opération de recuit d'amorce de défauts conduisant à la séparation de la couche transférée du substrat « donneur. On procède ensuite à une opération de recuit de consolidation du collage puis à une opération de polissage mécano-chimique pour supprimer la couche de LiNbO$_3$ endommagée, rétablir une rugosité convenable (de l'ordre de 1 nm rms), et ajuster l'épaisseur de la couche transférée.

Dans une sixième étape illustrée en figure 12f, on procède au dépôt d'une couche d'aluminium sur une épaisseur de 200 nm par pulvérisation cathodique, puis photolithographie, puis définition de l'électrode supérieure E$_{2i}$, par gravure humide et retrait de résine. La figure 12f met en évidence la structure de résonateur HBAR selon l'invention comportant une zone de substrat S$_2$, une zone de cavité résonante C$_{R2}$ et une zone de transduction T$_2$.

Exemple de réalisation d'un résonateur HBAR de l'invention, à base de LiNbO$_3$ et utilisant la formation de structures acoustiques monolithiques enterrées.

En allant plus loin par rapport au mode de réalisation précédent, on peut directement réaliser la structure de manière monolithique en utilisant la propriété du niobate de lithium à réagir avec des atomes d'hydrogène via la réaction dite d'échange protonique et à former une nouvelle phase présentant des caractéristiques acoustiques différentes du matériau d'origine.

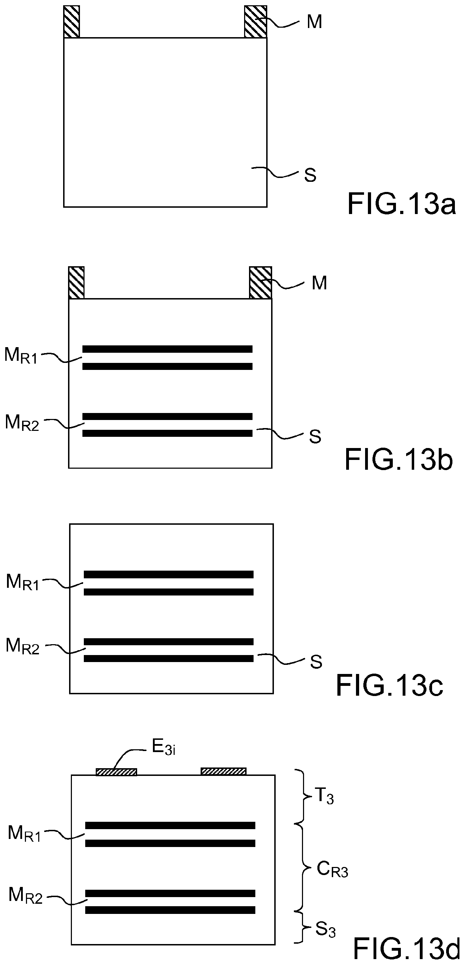

Le Demandeur a décrit dans une précédente demande de brevet FR 10 58402 que cette propriété peut permettre la réalisation de résonateurs. L'un des modes de réalisation présentait déjà la réalisation d'un résonateur sur un miroir de Bragg. On reprend ce mode de réalisation pour former une microcavité complète enterrée et située sous un résonateur à excitation électrique latérale. Un exemple de procédé est décrit ci-après à l'aide des figures 13a à 13d.

Selon une première étape, illustré en figure 13a, on procède au nettoyage d'un substrat S, de niobate de lithium et à une opération de photolithographie pour définir un masque à l'implantation M.

Lors d'une seconde étape illustrée en figure 13b, on réalise des implantations d'hydrogène successives, par énergie décroissante, afin de former un profil d'implantation quasi - périodique. Ce profil permet ainsi de générer deux ensembles de miroirs acoustiques M$_{R1}$ et M$_{R2}$ séparés d'une microcavité.

Comme illustré en figure 13c, on procède au retrait du masque M puis à une opération de recuit d'homogénéisation.

Lors d'une étape ultérieure, illustrée en figure 13d, on procède au dépôt, photolithographie, gravure et retrait de résine pour définir les électrodes supérieures E$_{3i}$, par exemple en aluminium. La figure 13d met en évidence la structure de résonateur HBAR selon l'invention comportant une zone de substrat S$_3$, une zone de cavité résonante C$_{R3}$ et une zone de transduction T$_3$.

Exemple illustratif de réalisation d'un résonateur HBAR ne faisant pas partie de l'invention, à base de AIN sur Silicium utilisant une microcavité réalisée en silicium poreux.

Selon ce mode de réalisation, la structure peut être réalisée de manière monolithique, dans un matériau semiconducteur que l'on peut rendre poreux par une attaque électrochimique. L'exemple le plus classique est le silicium rendu poreux par une attaque électrochimique dans une solution d'acide fluorhydrique (HF). Il est déjà connu que des structures de miroirs acoustiques et des microcavités peuvent être réalisés par cette technique, comme décrit dans l'article de G.N. Aliev, B. Goller, D. Kovalev and P.A. Snow, Hypersonic acoustic mirrors and microcavities in porous silicon, Applied Physics Letters 96, 124101 (2010). A noter que d'autres substrats semiconducteurs, comme le GaAs ou le Ge, peuvent également être porosifiés par une gravure électrochimique, et peuvent être utilisés de manière analogue pour réaliser des structures de miroirs ou de microcavités acoustiques.

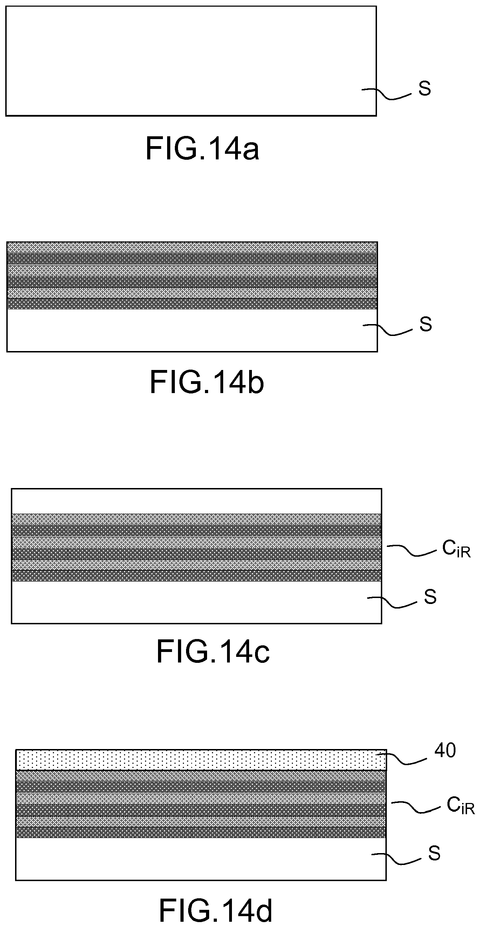

Par ailleurs, il est possible de reboucher les pores en surface par un dépôt par épitaxie de silicium, suivi d'une oxydation thermique et d'une planarisation afin de réduire la rugosité induite par la présence de pores sous la surface. A partir de ce substrat, on peut poursuivre la réalisation de résonateurs HBAR de manière conventionnelle. Un procédé de réalisation est alors le suivant : Selon une première étape illustrée en figure 14a, on part d'un substrat S, en silicium dopé au bore (résistivité de 10 à 15 mΩ.cm) que l'on nettoie par un bain de type RCA (mélange d'eau déionisée, d'acide chlorhydrique et d'eau oxygénée), puis on procède à une opération de désoxydation dans une solution d'HF dilué.

Dans une seconde étape, illustrée en figure 14b, on procède à la gravure électrochimique dans une solution 1:1 de HF concentré à 49 % et d'éthanol. Durant la gravure, l'intensité du courant est variée périodiquement dans le temps, de manière à fournir une alternance de 6 couches de porosités C$_{Ri}$ respectives de 47 et 61 %. On poursuit par la gravure d'une couche de 61 % de porosité gravée à un temps double, puis on reprend de nouveau la gravure d'une alternance de 6 couches.

Dans une troisième étape, illustré en figure 14c, on réalise le dépôt de silicium épitaxié sur une épaisseur de 500 nm de manière à reboucher les pores.

Dans une quatrième étape, illustrée en figure 14d, on procède à une opération d'oxydation thermique sur 200 nm puis à une opération de planarisation pour définir la couche d'oxyde 40.

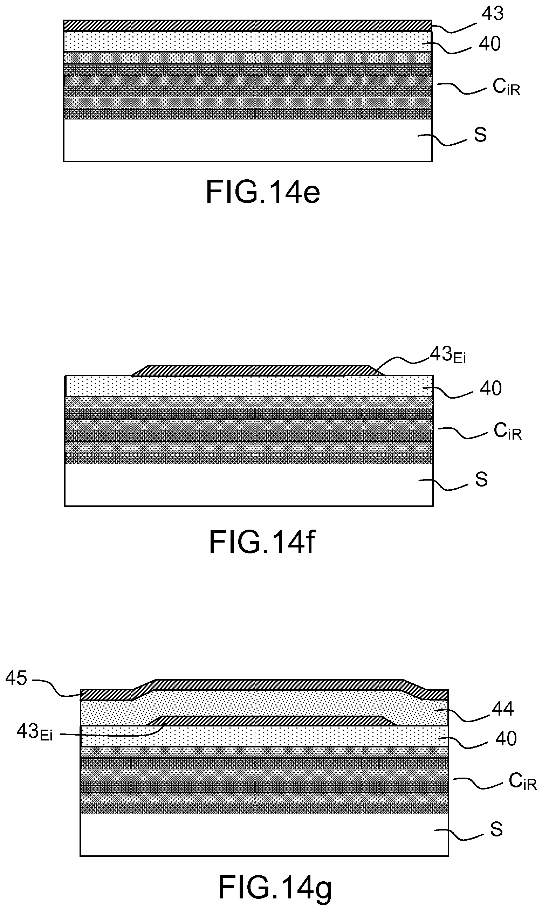

Selon une cinquième étape, illustrée en figure 14e, on procède au dépôt d'une couche d'accroche puis au dépôt d'une couche 43 de Molybdène (200 nm) par pulvérisation cathodique.

Selon une sixième étape, illustrée en figure 14f, on réalise des opérations d'enduction de résine et lithographie, puis fluage à 200°C pendant 15 minutes de gravure sèche (RIE) fluorée du Mo, puis retrait de résine de manière à définir une électrode inférieure $43_{Ei}$.

Selon une septième étape illustrée en figure 14g, on réalise le dépôt d'une couche 44 d'AlN ($1 \mu m$) par pulvérisation cathodique réactive DC puisée, à une température de 300°C, puis on procède au dépôt d'une couche 45 de molybdène Mo (200 nm) par pulvérisation cathodique.

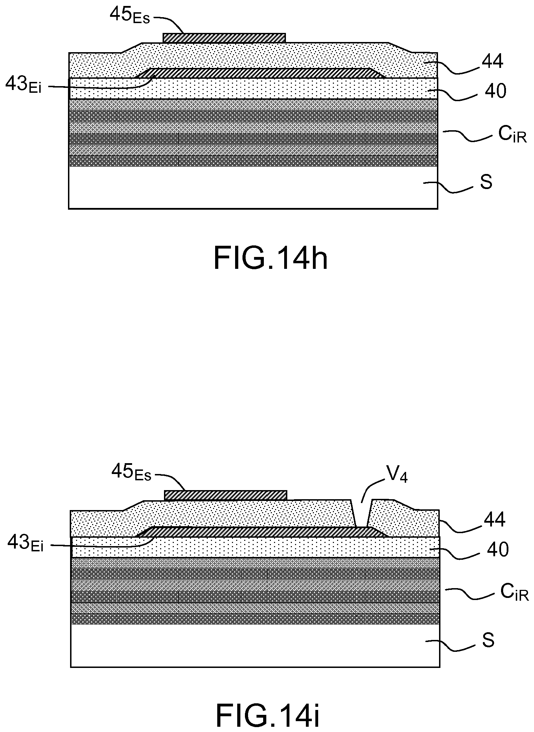

Selon une huitième étape illustrée en figure 14h, on procède à l'enduction de résine et à des opérations de lithographie, de gravure sèche fluorée du Mo et retrait de résine pour définir l'électrode supérieure $45_{Es}$.

Selon une neuvième étape illustré en figure 14i, on procède à l'enduction de résine et à des opérations de lithographie, gravure humide de l'AlN dans un bain de $H_3PO_4$ à 130°C, rinçage, et retrait de résine pour définir un via $V_4$.

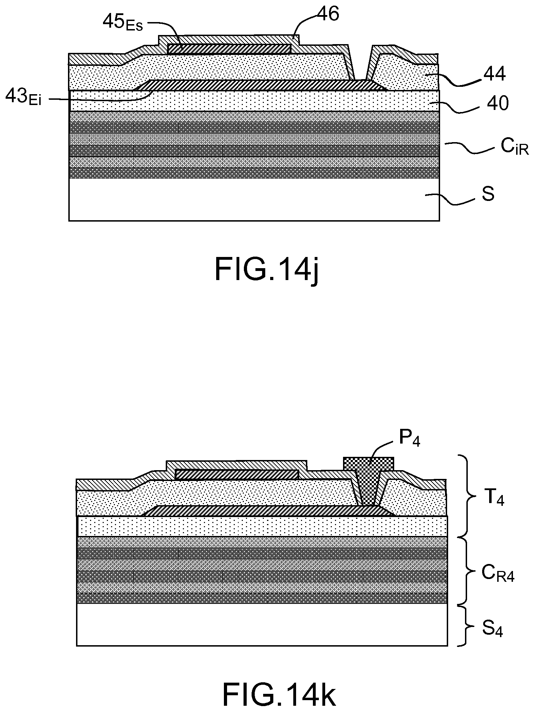

Selon une dixième étape illustrée en figure 14j, on procède au dépôt d'une couche 46 de nitrure de silicium (SiN) par PECVD (200 nm), enduction de résine et lithographie, puis à une opération de gravure sèche et retrait de résine.

Selon une onzième étape illustrée en figure 14k), on procède alors à un dépôt d'Aluminium-cuivre ($1 \mu m$) par pulvérisation cathodique puis à des opérations d'enduction de résine, lithographie et gravure sèche chlorée, rinçage et retrait de résine de manière à définir un plot de contact $P_4$ permettant de connecter l'électrode inférieure. La figure 14k met ainsi en évidence la structure de résonateur HBAR selon l'invention comportant une zone de substrat $S_4$, une zone de cavité résonante $C_{R4}$ et un zone de transduction $T_4$.

## Revendications

1. Résonateur HBAR « High-overtone Bulk Acoustic resonator » comportant un substrat ($S_1$, $S_2$, $S_3$, $S_4$), un transducteur piézoélectrique ($T_1$, $T_2$, $T_3$, $T_4$), ledit transducteur comprenant au moins une couche piézoélectrique, au moins deux électrodes et présentant des fréquences de résonance Fi correspondant à des longueurs d'onde $\lambda i$, le résonateur comprenant en outre :

    - une structure d'amplification comportant au moins une cavité résonante ($C_{R1}$, $C_{R2}$, $C_{R3}$,

$C_{R4}$) disposée sur le substrat entre ledit transducteur et ledit substrat ou dans ledit substrat, cette structure d'amplification étant apte à résonner mécaniquement à au moins une des fréquences de résonance Fi dudit transducteur correspondant à ladite longueur d'onde $\lambda i$, de façon à amplifier l'amplitude de la résonance mécanique générée à ladite fréquence ;

    - la cavité résonante présentant un spectre de transmission acoustique **caractérisé par** des niveaux relativement bas, typiquement pouvant être inférieur à environ 0,5 et ce sur une gamme de fréquence encadrant la au moins fréquence Fi de travail, mais avec des pics de transmission localisés à la fréquence Fi d'intérêt ;

    - ladite cavité présentant une épaisseur sensiblement égale à $n\lambda i/2$ avec n entier non nul

    **caractérisé en ce que** :

    - la cavité résonante est composée d'une couche demi-onde d'AlN encadrée par deux miroirs de Bragg partiels composés de couches quart d'onde de $SiO_2$ et d'AlN ou
    - la cavité résonante est définie dans ledit substrat, et délimitée par des structures élémentaires de miroirs réfléchissants à ladite fréquence Fi ($M_{R1}$, $M_{R2}$) enterrées dans ledit substrat, ces structures faisant partie de ladite cavité résonante.

2. Résonateur HBAR selon la revendication 1 , **caractérisé en ce que** le transducteur comporte une électrode inférieure et une électrode supérieure.

3. Résonateur HBAR selon l'une des revendications 1 ou 2, **caractérisé en ce que** le transducteur comporte deux électrodes supérieures.

4. Résonateur HBAR selon l'une des revendications 1 à 3, **caractérisé en ce que** le substrat est en saphir, ou en quartz, ou en niobate de lithium, ou en tantalate de lithium, ou en corindon ou en silicium, ou en germanium ou en arséniure de gallium.

5. Résonateur HBAR selon l'une des revendications 1 à 4, **caractérisé en ce que** la couche piézoélectrique est en AlN, ou en $LiNbO_3$.

6. Procédé de réalisation d'un résonateur HBAR « High-overtone Bulk Acoustic resonator » comportant sur un substrat ($S_1$, $S_2$, $S_3$, $S_4$), un transducteur piézoélectrique ($T_1$, $T_2$, $T_3$, $T_4$), ledit transducteur comprenant au moins une couche piézoélectrique, au moins deux électrodes et présentant des fréquences de résonance Fi correspondant à des longueurs d'onde $\lambda i$, le résonateur comprenant en outre :

- une structure d'amplification comportant au moins une cavité résonante ($C_{R1}$, $C_{R2}$, $C_{R3}$, $C_{R4}$) disposée sur le substrat entre ledit transducteur et ledit substrat, cette structure d'amplification étant apte à résonner mécaniquement à au moins une des fréquences de résonance Fi dudit transducteur correspondant à ladite longueur d'onde $\lambda$i, de façon à amplifier l'amplitude de la résonance mécanique générée à ladite fréquence ;
- la cavité résonante présentant un spectre de transmission acoustique **caractérisé par** des niveaux relativement bas, typiquement pouvant être inférieur à environ 0,5 et ce sur une gamme de fréquence encadrant la au moins fréquence Fi de travail, mais avec des pics de transmission localisés à la fréquence Fi d'intérêt ;
- ladite cavité présentant une épaisseur sensiblement égale à $n\lambda i/2$ avec n entier non nul ;
- la cavité résonante étant composée d'une couche demi-onde d'AlN encadrée par deux miroirs de Bragg partiels composés de couches quart d'onde de $SiO_2$ et d'AlN

ledit procédé comprenant les étapes suivantes :

- la réalisation sur le substrat, de ladite structure d'amplification comportant au moins une cavité résonante ($C_{R1}$, $C_{R2}$, $C_{R3}$, $C_{R4}$) apte à résonner mécaniquement à au moins une des fréquences de résonance Fi dudit transducteur correspondant à ladite longueur d'onde $\lambda$i, la cavité résonante présentant un spectre de transmission acoustique **caractérisé par** des niveaux relativement bas, typiquement pouvant être inférieur à environ 0,5 et ce sur une large gamme de fréquence encadrant les fréquences Fi de travail, mais avec des pics de transmission localisés à la fréquence Fi d'intérêt et présentant une épaisseur sensiblement égale à $n\lambda i/2$ avec n entier non nul.
- la réalisation dudit transducteur de façon à ce qu'il soit disposé à la surface de ladite cavité.

**7.** Procédé de réalisation d'un résonateur HBAR « High-overtone Bulk Acoustic resonator » comportant un substrat ($S_1$, $S_2$, $S_3$, $S_4$), un transducteur piézoélectrique ($T_1$, $T_2$, $T_3$, $T_4$), ledit transducteur comprenant au moins une couche piézoélectrique, au moins deux électrodes et présentant des fréquences de résonance Fi correspondant à des longueurs d'onde $\lambda$i le résonateur comprenant en outre :

- une structure d'amplification comportant au moins une cavité résonante ($C_{R1}$, $C_{R2}$, $C_{R3}$, $C_{R4}$) dans ledit substrat, cette structure d'amplification étant apte à résonner mécaniquement à au moins une des fréquences de résonance Fi dudit transducteur correspondant à ladite longueur d'onde $\lambda$i, de façon à amplifier l'amplitude de la résonance mécanique générée à ladite fréquence ;
- la cavité résonante étant définie dans ledit substrat, et délimitée par des structures élémentaires de miroirs réfléchissants à ladite fréquence Fi ($M_{R1}$, $M_{R2}$) enterrées dans ledit substrat, ces structures faisant partie de ladite cavité résonante,

ledit procédé comprenant :

- la réalisation dans une plaque de matériau piézoélectrique, de miroirs réfléchissants ($M_{R1}$, $M_{R2}$) à la fréquence Fi ;

  • lesdits miroirs étant enterrés sous une épaisseur de la plaque piézoélectrique définissant la couche piézoélectrique dudit transducteur et définissant entre eux une cavité résonante ($C_{R3}$) comprenant une couche piézoélectrique d'épaisseur égale à $n\lambda i/2$ avec n entier non nul ;

- la réalisation d'électrodes sur ladite plaque.

**8.** Procédé de réalisation d'un résonateur HBAR selon l'une des revendications 6 ou 7, comportant la réalisation dudit transducteur piézoélectrique ($T_2$) sur un substrat hôte ($S_2$), **caractérisé en ce qu'**il comprend les étapes suivantes :

- la réalisation d'une première partie d'une cavité résonante à la surface d'un substrat donneur ($S_1$) en matériau piézoélectrique ;
- la réalisation d'une seconde partie de ladite cavité résonante à la surface d'un substrat hôte ($S_2$) ;
- le collage de la première et de la seconde parties de la cavité résonante de manière à définir une cavité résonante unique à la fréquence Fi;
- une opération de délimitation d'une couche de matériau dans ledit substrat donneur ($S_1$) de manière à obtenir ladite couche de matériau piézoélectrique ;
- la réalisation d'au moins une électrode ($E_{2i}$) à la surface de ladite couche piézoélectrique séparée.

**9.** Procédé de réalisation d'un résonateur HBAR selon la revendication 8, **caractérisée en ce que** la première et la deuxième parties étant des demi cavités, chacune de ces demi cavités comprend le dépôt d'une couche d'épaisseur égale à $n\lambda i/4$ avec n entier non nul,

**10.** Procédé de réalisation d'un résonateur HBAR selon la revendication 8 ou 9, **caractérisé en ce que** l'opération de délimitation d'une couche de matériau dans ledit substrat donneur comprend :

- la réalisation d'une zone fragilisée dans ledit substrat de manière à délimiter dans ledit substrat, ladite couche piézoélectrique ;
- la séparation de ladite couche piézoélectrique dudit substrat donneur.

**11.** Procédé de réalisation d'un résonateur HBAR selon la revendication 10, **caractérisé en ce que** la réalisation d'une zone fragilisée dans ledit substrat est effectuée par implantation.

**12.** Procédé de réalisation d'un résonateur HBAR selon la revendication 8 ou 9, **caractérisé en ce que** l'opération de délimitation d'une couche de matériau dans ledit substrat donneur comprend une opération d'amincissement dudit substrat donneur.

**13.** Procédé de fabrication d'un résonateur HBAR selon l'une des revendications 8 à 12, **caractérisé en ce que** les substrats donneur et hôte sont en LiNbO$_3$.

**14.** Procédé de réalisation d'un résonateur HBAR selon l'une des revendications 8 à 13, **caractérisé en ce que** le collage des deux demi-cavités est un collage moléculaire.

**15.** Procédé de réalisation d'un résonateur HBAR selon l'une des revendications 8 à 14, **caractérisé en ce qu'**il comporte en outre une opération préalable de réalisation d'une couche de contact métallique (20) à la surface dudit substrat hôte.

**16.** Procédé de réalisation d'un résonateur HBAR selon la revendication 7, **caractérisé en ce que** le matériau piézoélectrique de la plaque est en niobate de lithium.

**17.** Procédé de fabrication d'un résonateur HBAR selon l'une des revendications 7 ou 16, **caractérisé en ce que** les miroirs sont réalisés par implantation d'atomes ou d'ions à des énergies différentes de manière à régler la profondeur d'implantation.

**Patentansprüche**

**1.** HBAR-(High-overtone Bulk Acoustic Resonator)-Resonator mit einem Substrat ($S_1$, $S_2$, $S_3$, $S_4$), einem piezoelektrischen Wandler ($T_1$, $T_2$, $T_3$, $T_4$), wobei der Wandler mindestens eine piezoelektrische Schicht und mindestens zwei Elektroden umfasst und Resonanzfrequenzen Fi aufweist, die den Wellenlängen λi entsprechen, wobei der Resonator ferner Folgendes umfasst:

- eine Verstärkungsstruktur mit mindestens einem Resonanzhohlraum ($C_{R1}$, $C_{R2}$, $C_{R3}$, $C_{R4}$), der auf dem Substrat zwischen dem Wandler und dem Substrat oder in dem Substrat angeordnet ist, wobei diese Verstärkungsstruktur bei mindestens einer der Resonanzfrequenzen Fi des Wandlers, die der Wellenlänge λi entspricht, mechanisch mitschwingen kann, um die Amplitude der bei der Frequenz erzeugten mechanischen Resonanz zu verstärken;
- wobei der Resonanzhohlraum ein akustisches Übertragungsspektrum aufweist, das durch relativ niedrige Pegel die typischerweise weniger als etwa 0,5 sein können, und zwar über einen Frequenzbereich, der zumindest die Betriebsfrequenz Fi einrahmt, aber mit lokalisierten Übertragungsspitzen bei der Frequenz Fi von Interesse, gekennzeichnet ist;
- wobei der Hohlraum eine Dicke hat, die im Wesentlichen gleich nλi/2 ist, wobei n eine ganze Zahl ungleich Null ist;

**dadurch gekennzeichnet, dass**:

- der Resonanzhohlraum aus einer Halbwellenschicht aus AIN besteht, die von zwei partiellen Bragg-Spiegeln aus Viertelwellenschichten aus SiO$_2$ und AIN eingerahmt ist, oder
- der Resonanzhohlraum in dem Substrat definiert und durch elementare Strukturen von Spiegeln begrenzt ist, die bei der Frequenz Fi ($M_{R1}$, $M_{R2}$) reflektieren und in dem Substrat eingebettet sind, wobei diese Strukturen Teil des Resonanzhohlraums sind.

**2.** HBAR-Resonator nach Anspruch 1, **dadurch gekennzeichnet, dass** der Wandler eine untere und eine obere Elektrode umfasst.

**3.** HBAR-Resonator nach Anspruch 1 oder 2, **dadurch gekennzeichnet, dass** der Wandler zwei obere Elektroden aufweist.

**4.** HBAR-Resonator nach einem der Ansprüche 1 bis 3, **dadurch gekennzeichnet, dass** das Substrat aus Saphir oder Quarz oder Lithiumniobat oder Lithiumtantalat oder Korund oder Silicium oder Germanium oder Galliumarsenid hergestellt ist.

**5.** HBAR-Resonator nach einem der Ansprüche 1 bis 4, **dadurch gekennzeichnet, dass** die piezoelektrische Schicht aus AIN oder LiNbO$_3$ besteht.

**6.** Verfahren zur Herstellung eines HBAR-(High-overtone Bulk Acoustic Resonator)-Resonators, der auf einem Substrat ($S_1$, $S_2$, $S_3$, $S_4$) einen piezoelektrischen Wandler ($T_1$, $T_2$, $T_3$, $T_4$) umfasst, wobei der Wandler mindestens eine piezoelektrische Schicht und mindestens zwei Elektroden umfasst und Resonanzfrequenzen Fi aufweist, die Wellenlängen $\lambda i$ entsprechen, wobei der Resonator ferner Folgendes umfasst:

- eine Verstärkungsstruktur mit mindestens einem Resonanzhohlraum ($C_{R1}$, $C_{R2}$, $C_{R3}$, $C_{R4}$), der auf dem Substrat zwischen dem Wandler und dem Substrat angeordnet ist, wobei diese Verstärkungsstruktur bei mindestens einer der Resonanzfrequenzen Fi des Wandlers, die der Wellenlänge $\lambda i$ entspricht, mechanisch in Resonanz treten kann, um die Amplitude der bei dieser Frequenz erzeugten mechanischen Resonanz zu verstärken;

- wobei der Resonanzhohlraum ein akustisches Übertragungsspektrum aufweist, das durch relativ niedrige Pegel, die typischerweise weniger als etwa 0,5 sein können, und zwar über einen Frequenzbereich, der zumindest die Betriebsfrequenz Fi einrahmt, aber mit lokalisierten Übertragungsspitzen bei der Frequenz Fi von Interesse, gekennzeichnet ist;

- wobei der Hohlraum eine Dicke hat, die im Wesentlichen gleich $n\lambda i/2$ ist, wobei n eine ganze Zahl ungleich Null ist;

- wobei der Resonanzhohlraum aus einer Halbwellenschicht aus AIN besteht, die von zwei partiellen Bragg-Spiegeln eingerahmt ist, die aus Viertelwellenschichten aus $SiO_2$ und AIN bestehen,

wobei das Verfahren die folgenden Schritte beinhaltet:

- Herstellen der Verstärkungsstruktur auf dem Substrat, die mindestens einen Resonanzhohlraum ($C_{R1}$, $C_{R2}$, $C_{R3}$, $C_{R4}$) umfasst, der bei mindestens einer der Resonanzfrequenzen Fi des Wandlers, die der Wellenlänge $\lambda i$ entspricht, mechanisch in Resonanz treten kann, wobei der Resonanzhohlraum ein akustisches Übertragungsspektrum aufweist, das durch relativ niedrige Pegel, die typischerweise weniger als etwa 0,5 sein können, und zwar über einen breiten Frequenzbereich, der die Fi-Betriebsfrequenzen einrahmt, aber mit lokalisierten Übertragungsspitzen bei der Fi-Frequenz von Interesse und mit einer Dicke, die im Wesentlichen gleich $n\lambda i/2$ ist, wobei n eine ganze Zahl ungleich Null ist, gekennzeichnet ist.

- Herstellen des Fahrzeugwandlers, so dass er auf der Oberfläche des Hohlraums angeordnet ist.

7. Verfahren zur Herstellung eines HBAR-(High-overtone Bulk Acoustic Resonator)-Resonators, der ein Substrat ($S_1$, $S_2$, $S_3$, $S_4$), undeinen piezoelektrischen Wandler ($T_1$, $T_2$, $T_3$, $T_4$) umfasst, wobei der Wandler mindestens eine piezoelektrische Schicht und mindestens zwei Elektroden umfasst und Resonanzfrequenzen Fi hat, die Wellenlängen $\lambda i$ entsprechen, wobei der Resonator ferner Folgendes umfasst:

- eine Verstärkungsstruktur, die mindestens einen Resonanzhohlraum ($C_{R1}$, $C_{R2}$, $C_{R3}$, $C_{R4}$) in dem Substrat umfasst, wobei diese Verstärkungsstruktur bei mindestens einer der Resonanzfrequenzen Fi des Wandlers, die der Wellenlänge $\lambda i$ entspricht, mechanisch in Resonanz treten kann, um die Amplitude der bei dieser Frequenz erzeugten mechanischen Resonanz zu verstärken;

- wobei der Resonanzhohlraum in dem Substrat definiert und durch elementare Spiegelstrukturen begrenzt ist, die bei der Frequenz Fi ($M_{R1}$, $M_{R2}$) reflektieren und die in dem Substrat eingebettet sind, wobei diese Strukturen Teil des Resonanzhohlraums sind,

wobei das Verfahren Folgendes beinhaltet:

- Herstellen von bei der Frequenz Fi reflektierenden Spiegeln ($M_{R1}$, $M_{R2}$) in einer Platte aus piezoelektrischem Material;

• wobei die Spiegel unter einer Dicke der piezoelektrischen Platte eingebettet sind, die die piezoelektrische Schicht des Wandlers definiert und dazwischen einen Resonanzhohlraum ($C_{R3}$) definiert, der eine piezoelektrische Schicht mit einer Dicke gleich $n\lambda i/2$ umfasst, wobei n eine ganze Zahl ungleich Null ist;

- Herstellen von Elektroden auf der Platte.

8. Verfahren zur Herstellung eines HBAR-Resonators nach Anspruch 6 oder 7, das die Herstellung des piezoelektrischen Wandlers ($T_2$) auf einem Wirtssubstrat ($S_2$) beinhaltet, **dadurch gekennzeichnet, dass** es die folgenden Schritte beinhaltet:

- Herstellen eines ersten Teils eines Resonanzhohlraums auf der Oberfläche eines Donorsubstrats (Si) aus piezoelektrischem Material;

- Herstellen eines zweiten Teils des Resonanzhohlraums auf der Oberfläche eines Wirtssubstrats ($S_2$);

- Verbinden des ersten und zweiten Teils des Resonanzhohlraums, um einen einzigen Resonanzhohlraum mit der Frequenz Fi zu definieren;

- einen Vorgang des Abgrenzens einer Materialschicht in dem Donorsubstrat ($S_1$), um die pi-

ezoelektrische Materialschicht zu erhalten;
- Herstellen mindestens einer Elektrode ($E_{2i}$) auf der Oberfläche der getrennten piezoelektrischen Schicht.

9.  Verfahren zur Herstellung eines HBAR-Resonators nach Anspruch 8, **dadurch gekennzeichnet, dass** der erste und der zweite Teil Halbhohlräume sind, wobei jeder dieser Halbhohlräume das Absetzen einer Schicht mit einer Dicke gleich $n\lambda i/4$ umfasst, wobei n eine ganze Zahl ungleich Null ist.

10. Verfahren zur Herstellung eines HBAR-Resonators nach Anspruch 8 oder 9, **dadurch gekennzeichnet, dass** der Vorgang des Abgrenzens einer Materialschicht in dem Donorsubstrat Folgendes beinhaltet:

    - Herstellen einer geschwächten Zone in dem Substrat, um so die piezoelektrische Schicht in dem Substrat abzugrenzen;
    - Trennen der piezoelektrischen Schicht von dem Donorsubstrat.

11. Verfahren zur Herstellung eines HBAR-Resonators nach Anspruch 10, **dadurch gekennzeichnet, dass** die Herstellung einer geschwächten Zone in dem Substrat durch Implantation durchgeführt wird.

12. Verfahren zur Herstellung eines HBAR-Resonators nach Anspruch 8 oder 9, **dadurch gekennzeichnet, dass** der Schritt des Abgrenzens einer Materialschicht in dem Donorsubstrat einen Vorgang des Verdünnens des Donorsubstrats beinhaltet.

13. Verfahren zur Herstellung eines HBAR-Resonators nach einem der Ansprüche 8 bis 12, **dadurch gekennzeichnet, dass** die Donor- und Wirtssubstrate aus $LiNbO_3$ sind.

14. Verfahren zur Herstellung eines HBAR-Resonators nach einem der Ansprüche 8 bis 13, **dadurch gekennzeichnet, dass** die Verbindung der beiden Halbhohlräume eine molekulare Verbindung ist.

15. Verfahren zur Herstellung eines HBAR-Resonators nach einem der Ansprüche 8 bis 14, **dadurch gekennzeichnet, dass** es ferner einen Vorabvorgang des Herstellens einer Metallkontaktschicht (20) auf der Oberfläche des Wirtssubstrats beinhaltet.

16. Verfahren zur Herstellung eines HBAR-Resonators nach Anspruch 7, **dadurch gekennzeichnet, dass** das piezoelektrische Material der Platte Lithiumniobat ist.

17. Verfahren zur Herstellung eines HBAR-Resonators nach Anspruch 7 oder 16, **dadurch gekennzeichnet, dass** die Spiegel durch Implantation von Atomen oder Ionen mit unterschiedlichen Energien hergestellt werden, um die Implantationstiefe zu regeln.

## Claims

1.  HBAR resonator comprising a substrate ($S_1$, $S_2$, $S_3$, $S_4$), a piezoelectric transducer ($T_1$, $T_2$, $T_3$, $T_4$), said transducer comprising at least one piezoelectric layer, at least two electrodes and exhibiting resonance frequencies Fi corresponding to wavelengths $\lambda i$, the resonator further comprising:

    - an amplification structure comprising at least one resonant cavity ($C_{R1}$, $C_{R2}$, $C_{R3}$, $C_{R4}$) arranged on the substrate between said transducer and said substrate or in said substrate, this amplification structure being suitable for mechanically resonating at at least one of the resonance frequencies Fi of said transducer corresponding to said wavelength $\lambda i$, so as to amplify the amplitude of the mechanical resonance generated at said frequency.
    - the resonant cavity exhibiting an acoustic transmission spectrum **characterized by** relatively low levels, typically being able to be less than approximately 0.5and this over a frequency range surrounding at least the working frequencies Fi, but with localized transmission peaks at the frequency Fi of interest;
    - said cavity exhibiting a thickness substantially equal to $n\lambda i/2$ with n being a non-zero integer

    **characterized in that**:

    - the resonant cavity consists of a half-wave layer of AIN bracketed by two partial Bragg mirrors consisting of quarter-wave layers of $SiO_2$ and AIN or
    - the resonant cavity is defined in said substrate, and is delimited by basic mirror structures reflecting at said frequency Fi ($M_{R1}$, $M_{R2}$) buried in said substrate, these structures forming part of said resonant cavity.

2.  HBAR resonator according to Claim 1, **characterized in that** the transducer comprises a bottom electrode and a top electrode.

3.  HBAR resonator according to one of Claims 1 or 2, **characterized in that** the transducer comprises two top electrodes.

4.  HBAR resonator according to one of Claims 1 to 3, **characterized in that** the substrate is made of sapphire, or of quartz, or of lithium niobate, or of lithium tantalate, or of corindon or of silicon, or of germanium or of gallium arsenide.

5. HBAR resonator according to one of Claims 1 to 4, **characterized in that** the piezoelectric layer is of AlN, or of LiNbO$_3$.

6. Method for producing an HBAR resonator comprising on a substrate (S$_1$, S$_2$, S$_3$, S$_4$) a piezoelectric transducer (T$_1$, T$_2$, T$_3$, T$_4$), said transducer comprising at least one piezoelectric layer, at least two electrodes and exhibiting resonance frequencies Fi corresponding to wavelengths λi, the resonator further comprising:

   - an amplification structure comprising at least one resonant cavity (C$_{R1}$, C$_{R2}$, C$_{R3}$, C$_{R4}$) arranged on the substrate between said transducer and said substrate, this amplification structure being suitable for mechanically resonating at at least one of the resonance frequencies Fi of said transducer corresponding to said wavelength λi, so as to amplify the amplitude of the mechanical resonance generated at said frequency;
   - the resonant cavity exhibiting an acoustic transmission spectrum **characterized by** relatively low levels, typically being able to be less than approximately 0.5, and this over a wide frequency range bracketing the working frequencies Fi, but with localized transmission peaks at the frequency Fi of interest;
   - said cavity exhibiting a thickness substantially equal to nλi/2 with n being a non-zero integer;
   - the resonant cavity consisting of a half-wave layer of AlN bracketed by two partial Bragg mirrors consisting of quarter-wave layers of SiO$_2$ and AlN

   said method comprising the following steps:

   - the production, on the substrate, of said amplification structure comprising at least one resonant cavity (C$_{R1}$, C$_{R2}$, C$_{R3}$, C$_{R4}$) suitable for mechanically resonating at at least one of the resonance frequencies Fi of said transducer corresponding to said wavelength λi, the resonant cavity exhibiting an acoustic transmission spectrum **characterized by** relatively low levels, typically being able to be less than approximately 0.5, and this over a wide frequency range bracketing the working frequencies Fi, but with localized transmission peaks at the frequency Fi of interest and exhibiting a thickness substantially equal to nλi/2 with n being a non-zero integer.
   - the production of said transducer in such a way that it is arranged on the surface of said cavity.

7. Method for producing an HBAR resonator comprising a substrate (S$_1$, S$_2$, S$_3$, S$_4$) and a piezoelectric transducer (T$_1$, T$_2$, T$_3$, T$_4$), said transducer comprising at least one piezoelectric layer and at least two electrodes and exhibiting resonance frequencies Fi corresponding to wavelengths λi, the resonator further comprising:

   - an amplification structure comprising at least one resonant cavity (C$_{R1}$, C$_{R2}$, C$_{R3}$, C$_{R4}$) in said substrate, suitable for mechanically resonating at at least one of the resonance frequencies Fi of said transducer corresponding to said wavelength λi, so as to amplify the amplitude of the mechanical resonance generated at said frequency;
   - the resonant cavity being defined in said substrate, and delimited by basic mirror structures reflecting at said frequency Fi (M$_{R1}$, M$_{R2}$) buried in said substrate, these structures forming part of said resonant cavity,

   said method comprising:
   the production, in a plate of piezoelectric material, of mirrors (M$_{R1}$, M$_{R2}$) reflecting at the frequency Fi;

   • said mirrors being buried under a thickness of the piezoelectric plate defining the piezoelectric layer of said transducer and defining between them a resonant cavity (C$_{R3}$) comprising a piezoelectric layer of thickness equal to nλi/2 with n being a non-zero integer;

   - the production of electrodes on said transducer.

8. Method for producing an HBAR resonator according to one of Claims 6 or 7, comprising the production of said piezoelectric transducer (T$_2$) on a host substrate (S$_2$), **characterized in that** it comprises the following steps:

   - the production of a first part of a resonant cavity on the surface of a donor substrate (S$_1$) made of piezoelectric material;
   - the production of a second part of said resonant cavity on the surface of a host substrate (S$_2$);
   - the bonding of the first and second parts of the resonant cavity so as to define a single resonant cavity at the frequency Fi;
   - an operation of delimiting a layer of material in said donor substrate (S$_1$) so as to obtain said layer of piezoelectric material;
   - the production of at least one electrode (E$_{2i}$) on the surface of said separate piezoelectric layer.

9. Method for producing an HBAR resonator according to Claim 8, **characterized in that** the first and second parts being half-cavities, each of these half-cavities comprises the deposition of a layer of thickness equal to nλi/4 with n being a non-zero integer.

**10.** Method for producing an HBAR resonator according to Claim 8 or 9, **characterized in that** the operation of delimiting a layer of material in said donor substrate comprises:

> - the production of an embrittled region in said substrate so as to delimit, in said substrate, said piezoelectric layer;
> - the separation of said piezoelectric layer from said donor substrate.

**11.** Method for producing an HBAR resonator according to Claim 10, **characterized in that** the production of an embrittled region in said substrate is performed by implantation.

**12.** Method for producing an HBAR resonator according to Claim 8 or 9, **characterized in that** the operation of delimiting a layer of material in said donor substrate comprises an operation of thinning said donor substrate.

**13.** Method for fabricating an HBAR resonator according to one of Claims 8 to 12, **characterized in that** the donor and host substrates are of $LiNbO_3$.

**14.** Method for producing an HBAR resonator according to one of Claims 8 to 13, **characterized in that** the bonding of the two half-cavities is a molecular bonding.

**15.** Method for producing an HBAR resonator according to one of Claims 8 to 14, **characterized in that** it further comprises a preliminary operation of producing a metallic contact layer (20) on the surface of said host substrate.

**16.** Method for producing an HBAR resonator according to Claim 7, **characterized in that** the piezoelectric material of the plate is of lithium niobate.

**17.** Method for fabricating an HBAR resonator according to one of Claims 7 or 16, **characterized in that** the mirrors are produced by implanting atoms or ions at different energies so as to adjust the depth of implantation.

FIG.1

FIG.2

FIG.3a

FIG.3b

FIG.4

FIG.5

FIG.6

FIG.7

FIG.8a

FIG.8b

FIG.8c

FIG.8d

FIG.9

FIG.10

FIG.11a

FIG.11b

FIG.11c

FIG.11d

FIG.11e

FIG.11f

FIG.11g

FIG.11h

FIG.12a

FIG.12b

FIG.12c

FIG.12d

FIG.12e

FIG.12f

M

S

FIG.13a

M

$M_{R1}$

$M_{R2}$

S

FIG.13b

$M_{R1}$

$M_{R2}$

S

FIG.13c

$E_{3i}$

$T_3$

$M_{R1}$

$C_{R3}$

$M_{R2}$

$S_3$

FIG.13d

FIG.14a

FIG.14b

FIG.14c

FIG.14d

43

40

C$_{iR}$

S

FIG.14e

43$_{Ei}$

40

C$_{iR}$

S

FIG.14f

45

44

43$_{Ei}$

40

C$_{iR}$

S

FIG.14g

## FIG.14h

## FIG.14i

EP 2 642 662 B1

FIG.14j

FIG.14k

32

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2006119453 A
- US 5864261 A
- FR 2938136, de D. Gachon et S. Ballandras
- FR 1058402

### Littérature non-brevet citée dans la description

- **DE H. ZHANG, W. ; PANG, H. YU ; E.S. KIM.** High-tone bulk acoustic resonators on sapphire, crystal quartz, fused silica and silicon substrates. *J. Appl. Phys.,* 2006, vol. 99, 124911
- **DE H.L. SALVO ; M. GOTTLIEB ; B.R. MCAVOY.** Shear mode transducers for high-Q bulk microwave resonators. *Proceedings of the 41st Annual Frequency Control Symposium,* 1982, 388-390
- **DE D. GACHON ; E. COURJON ; J. MASSON ; V. PETRINI ; J.Y. RAUCH ; S. BALLANDRAS.** LiNbO3-LiNbO3 high overtone bulk acoustic resonator exhibiting high Q.f product. *Proceedings of the 2007 IEEE Ultrasonics Symposium,* 1417-1420
- **DE K.M. LAKIN ; G.R. KLINE ; K.T. MCCARRON.** High-Q microwave acoustic resonators and filters. *IEEE Transactions on Microwave Theory and Techniques,* 1993, vol. 41 (2), 2139-2146
- **DE G.R. KLINE ; K.M. LAKIN ; K.T. MCCARRON.** Overmoded high-Q resonators for microwave oscillators. *Proceedings of the 1993 IEEE International Frequency Control Symposium,* 718
- **DE M. PIJOLAT ; S. LOUBRIAT ; S. QUESTE ; D. MERCIER ; A. REINHARDT ; E. DEFAÿ ; C. DEGUET ; L. CLAVELIER ; H. MORICEAU ; M. AÏD.** Large electromechanical coupling factor film bulk acoustic resonator with X-cut LiNbO3 layer transfer. *Appl. Phys. Lett.,* 2009, vol. 95, 182106

- **DE W. PANG ; H. ZHANG ; J.J. KIM ; H. YU ; E.S. KIM.** High-Q single mode high-tone bulk acoustic resonator integrated with surface-micromachined FBAR filter. *Proceedings of the 2005 MTT-S International Microwave Symposium,* 2005, 413
- **DE A. REINHARDT.** Simulation, conception et réalisation de filtres à ondes de volume dans des couches minces piézoélectriques. Thèse de l'Université de Franche-Comté, 2005
- **PIJOLAT M et al.** LiNbO3 Film Bulk Acoustic Resonator. IEEE, 01 Juin 2010, 661-664
- **J.F. ROSENBAUM.** Bulk Acoustic Wave Theory and Devices. Artech House, 1945
- **A. REINHARDT ; T. PASTUREAUD ; S. BALLANDRAS ; V. LAUDE.** Scattering matrix method for modeling acoustic waves in piezoelectric, fluid and metallic multilayers. *Journ. Appl. Phys.,* 2003, vol. 94 (10), 6923-6931
- **DE M. PIJOLAT ; D. MERCIER ; A. REINHARDT ; E. DEFAÿ ; C. DEGUET ; M. AÏD ; J. S. MOULET ; B. GHYSELEN ; S. BALLANDRAS.** Mode conversion in high overtone bulk acoustic wave resonators. *Proceedings of the 2009 International Frequency Control Symposium,* 2009, 290-294
- **DE G.N. ALIEV ; B. GOLLER ; D. KOVALEV ; P.A. SNOW.** Hypersonic acoustic mirrors and microcavities in porous silicon. *Applied Physics Letters,* 2010, vol. 96, 124101